Europäisches Patentamt

European Patent Office

Office européen des brevets

(11) Publication number: 0 423 782 A2

# EUROPEAN PATENT APPLICATION

(21) Application number: 90119979.4

(22) Date of filing: 18.10.90

(51) Int. Cl.⁵: G03F 7/30

(30) Priority: 20.10.89 JP 274436/89

(43) Date of publication of application:
24.04.91 Bulletin 91/17

(84) Designated Contracting States:
DE GB

(71) Applicant: KONICA CORPORATION
26-2, Nishishinjuku 1-chome, Shinjuku-ku
Tokyo 160(JP)

(72) Inventor: Watanabe, Shinya
Konica Corporation, 1 Sakura-machi
Hino-shi, Tokyo(JP)

Inventor: Uehara, Masafumi
Konica Corporation, 1 Sakura-machi
Hino-shi, Tokyo(JP)
Inventor: Nogami, Akira
Konica Corporation, 1 Sakura-machi
Hino-shi, Tokyo(JP)
Inventor: Shimura, Kazuhiro
Konica Corporation, 1 Sakura-machi
Hino-shi, Tokyo(JP)

(74) Representative: Türk, Gille, Hrabal
Brucknerstrasse 20
W-4000 Düsseldorf 13(DE)

(54) Apparatus for processing pre-sensitized lithographic printing plate.

(57) An apparatus for developing an imagewise exposed pre-sensitized lithographic printing plate having a support and a light-sensitive layer with a developing solution that has not been substantially used, comprising;
(a) a means for applying the developing solution onto the surface of the light-sensitive layer,
(b) a brush roller for accelerating development and a roller provided beneath the brush roller,
(c) a pair of squeegee rollers for removing the developing solution from the surface of the light-sensitive layer consisting of an upper roller and a lower roller, and
(d) a means for passing said plate between said brush roller and said roller provided beneath the brush roller and then between said pair of squeegee rollers, said roller provided beneath the brush roller and said lower roller being immersedd in a tank that holds an aqueous alkaline solution and said brush roller and said upper roller not being immersed in said tank.

FIG. I

EP 0 423 782 A2

## APPARATUS FOR PROCESSING PRE-SENSITIZED LITHOGRAPHIC PRINTING PLATE

### FIELD OF THE INVENTION

The present invention relates to an apparatus for processing a pre-sensitized lithographic printing plate. More particularly, it relates to an apparatus suited to the processing by which a light-sensitive layer of a pre-sensitized lithographic printing plate (hereinafter often referred to as a PS plate) is imagewise dissolved out using an automatic processor.

### BACKGROUND OF THE INVENTION

Automatic processors have been hitherto used in the photographic processing of PS plates. When a PS plate having been exposed to light is processed using an automatic processor, methods have been used in which a developing solution is showered or sprayed on the surface of a PS plate while the PS plate is horizontally transported or a PS plate is immersed in a bent state in a processing tank holding a large quantity of developing solution. Because of the need for a large quantity of developing solution, the developing solution is circulated and reused taking account of economy.

In that case, a method has been used in which a developing solution replenisher is fed to keep photographic processing stable so that a developing solution can be recovered from its fatigue due to processing itself and carbon dioxide gas in the air.

Employment of such a replenishing system makes it unnecessary to frequently change the solution, but still requires a change of the solution. It has been also impossible to well control the fluctuation of the activity of developing solutions.

As a PS plate processing method that can stably process various kinds of PS plates without requiring such a troublesome management of developing solutions and also without requiring a complicated and expensive replenishing assembly, a method is known as disclosed in Japanese Patent Publication Open to Public Inspection (hereinafter referred to as Japanese Patent O.P.I. Publication) No. 71855/1988 which is a PS plate processing method in which a developing solution that has not been used is fed to a plate surface for each plate of PS plates to be processed, and thereafter the plate is immersed in a developing solution that is repeatedly used, subsequently passed through a development accelerating means, and then passed through an upper-and-lower pair of squeegee rollers to complete photographic processing. In this method, it has been carried out that a developing solution that has been used is fed through a shower nozzle to the development accelerating means and the squeegee roller to wash them so that they can be prevented from being contaminated. In such a method, however, a developing solution may be seriously fatigued because of carbon dioxide gas in the air, tending to generate precipitates in the developing solution. This has caused the problems that shower nozzles are clogged or the power of pumps is lowered to bring about a lowering of washing effect, so that the stain adhered to the development accelerating means and the squeegee roller may be transferred to the surface of a PS plate to cause stains at a non-image area at the time of printing. In addition, since a fatigued developing solution is circulated, the shower nozzle and piping must be frequently cleaned, bringing about the problem of a poor work efficiency.

### SUMMARY OF THE INVENTION

The present invention provides an apparatus for processing a pre-sensitized lithographic printing plate, that has solved the various problems involved in the above processing methods.

Accordingly, an object of the present invention is to provide an apparatus for processing a PS plate, that can prevent contamination of a development accelerating means and a squeegee roller and can obtain a printing plate having no stains at a non-image area at the time of printing.

Another object of the present invention is to provide an apparatus for processing a PS plate, that makes it unnecessary to carry out troublesome cleaning of shower nozzles, and pumps and piping thereof, used for washing development accelerating means and squeegee rollers, and thus can improve work efficiency.

The above object of the present invention can be achieved by an apparatus for developing an imagewise exposed pre-sensitized lithographic printing plate having a support and a light-sensitive layer with a developing solution that has not be substantially used, comprising;

(a) a means for applying the developing solution onto the surface of the light-sensitive layer,

(b) a brush roller for accelerating development and a roller provided beneath the brush roller,

(c) a pair of squeegee rollers for removing the developing solution from the surface of the light-sensitive layer consisting of an upper roller and a lower roller, and

(d) a means for passing said plate between said brush roller and said roller brovided beneath the brush roller and then between said pair of squeegee rollers, said roller provided between the brush roller and said lower roller being immersed in a tank that holds an aqueous alkaline solution and said brush roller and said upper roller not being immersed in said tank.

The above objects of the present invention can be better achieved by the apparatus as described above wherein at least one of said roller provided beneath the brush roller ans said lower roller is continuously rotated or intermittently rotated at given intervals. And further, at least one of said roller provided beneath the brush roller ans said lower lower is continuously rotated or intermittently rotated at given intervals, even while the feeding of the pre-sensitized lithographic printing plate is stopped.


BRIEF DESCRIPTION OF THE DRAWINGS


Figs. 1 to 4 are schematic cross-sectional illustrations of apparatus of the present invention.

Fig. 5 is a schematic cross-sectional illustration of an apparatus used in a comparative example.

DETAILED DESCRIPTION OF THE INVENTION


The apparatus of the present invention will be described below with reference to the drawings of the apparatus.

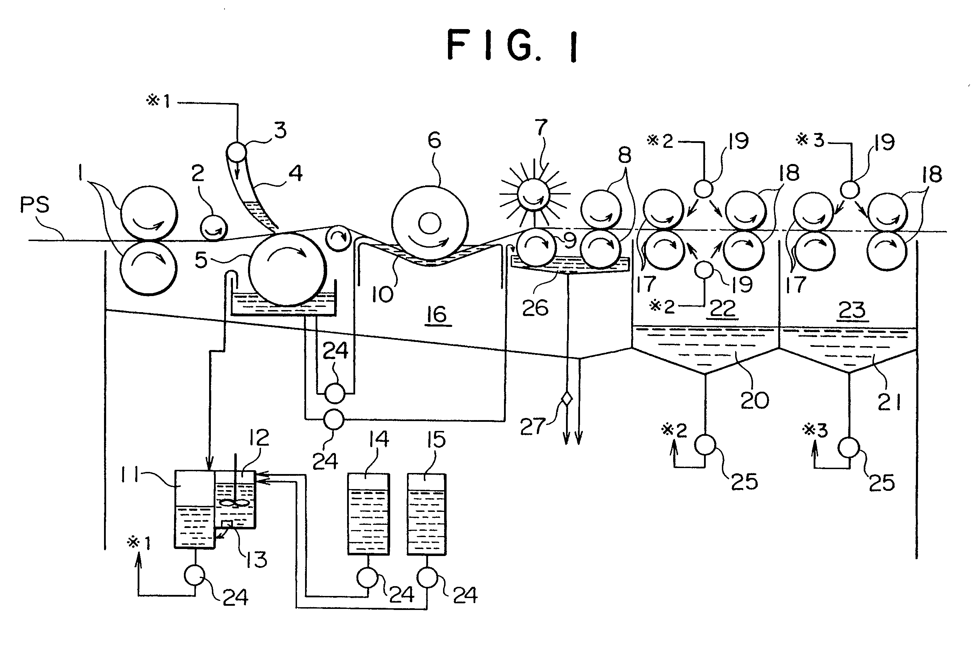

Fig. 1 is a schematic cross-sectional illustration of an example of a processing apparatus of the present invention. In Fig. 1, the numeral 4 denotes a developing solution feeding member from which a developing solution that has not been substantially used is fed to a plate surface for each plate of PS plates to be processed. The numeral 10 denotes a developing tank in which the PS plate is immersed in a developing solution repeatedly used. The numeral 7 denotes a development accelerating means. In this example, a brush roller is used. The numeral 8 denotes a squeegee rollers; 26, a tank that holds a developing solution (hereinafter "immersing tank"); and the letter symbol PS denotes a path through which the PS plates are fed and transported.

First, PS plates with their processing surfaces up are transported by means of transport rollers 1 from the left to right directions viewed in the drawing. The developing solution that has not been used is fed from the developing solution feeding member 4 so as to be uniformly coated on each plate surface of the PS plates.

The PS plates coated with the developing solution are transported in such a state that a developing solution coating thus formed can be held on the plate surface, and thereafter immersed in the developing solution in the developing tank 10. This immersion is for the purpose of giving no under-development area at the peripheries of the PS plates.

The PS plates are subsequently transported to the development accelerating means, where each plate surface is rubbed with the brush roller 7 and then the developing solution, dissolved components and so forth adhered to the surface of a PS plate are removed by means of the squeegee rollers 8. The brush roller 7 that can be used is exemplified by a roller comprised of a pipe of about 50 mm in diameter, made of vinyl chloride resin, and nylon hair of from about 0.05 to about 0.1 mm in diameter, set in the pipe in a hair length of from 10 to 20 mm.

The development accelerating means may not be the brush roller, and it is possible also to use a method in which a flat-sheet rubbing member is rotated to rub the plate surface, a method in which a flat-sheet rubbing member is frontward-backward and/or rightward-leftward slided to rub the plate surface, or a method in which, when the brush roller is used, the roll is frontward-backward and/or rightward-leftward swinged while it is rotated. These rubbing members may be used in combination of plural members. These rubbing members can be made using, for example, a brush, a sponge, a cloth and so forth.

A development accelerating means of a different type includes, for example, a method in which air under high pressure is sprayed, a method in which ultrasonic waves are irradiated, a method in which development is electrochemically carried out, as disclosed in Japanese Patent O.P.I. Publication No. 42042/1983, a method in which a developing solution on a PS plate is instantaneously heated by irradiation of microwaves, and a method in which a plate surface is honed using a treating solution containing a powdery abrasive.

In the present invention, a roller by which a PS plate is supported and transported is provided beneath the development accelerating means. A tank that holds a developing solution is provided in such a way that a lower part of the roller is immersed in the developing solution, and the roller is rotated. A tank is also provided in such a way that a lower part of a lower roller that constitutes the squeegee rollers is immersed in the developing solution.

Since the rollers are thus immersed, the above roller and the squeegee rollers are kept always wet, and also the developing solution can be delivered to the development accelerating means (for example, a brush roller) and an upper roll of the squeegee rollers so that they are also kept always wet. Hence, developing solution components, PS plate components dissolved out in a developing solution, precipitates produced in a developing solution, etc. can be prevented from being adhered to the rollers and the development accelerating means, dried thereon, and then transferred to the plate surfaces of PS plates to generate stains at the time of printing. In view of the effect of preventing contamination, it is therefore preferred for these rollers to be rotated also when the feeding of PS plates are stopped.

The roller 9 and squeegee rollers 8 that can be used may be each comprised of, for example, a rubbery material having a hardness of from 30 to 60 (JIS-A) and an impact resilience of not less than 50 %, as exemplified by silicone rubber (hardness: 40; impact resilience: 70 %), isoprene rubber (hardness: 50; impact resilience: 80 %), styrene rubber, butadiene rubber, chloroprene rubber, urethane rubber, and urethane-propylene rubber.

In the present invention, the means for feeding to plate surfaces of PS plates the developing solution that has not been substantially used, the means for immersing a PS plate in the developing solution repeatedly used, and the development accelerating means may not be limited to the above. Any methods including known methods can be employed.

In the present invention, the tanks in which the roller provided beneath the development accelerating means and the lower squeegee roller are immersed may be separately provided, or may be comprised of a common tank as shown by the numeral 26 in Fig. 1. The tank 26 in Fig. 1 has a relatively small depth so that the developing solution may be in a relatively small amount. For example, the developing solution in the tank 26 is thrown away together with the developing solution in the developing tank 10 after the day's operations have been completed.

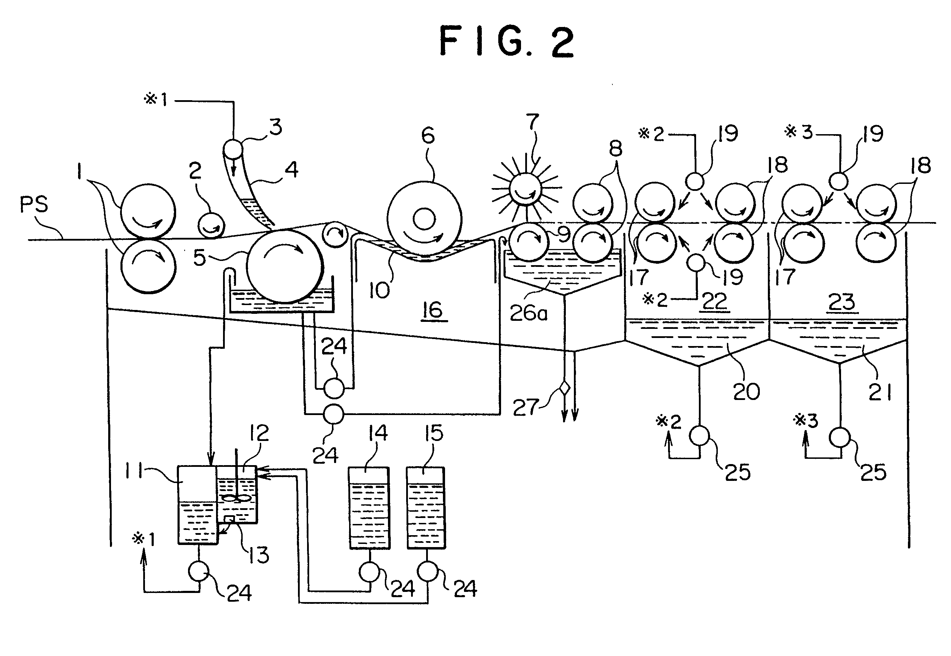

Fig. 2 is a cross-sectional illustration of another example of a processing apparatus of the present invention. In this example, a tank 26a that holds a developing solution has a relatively large depth so as to be in a capacity of from 3 to 5 lit. so that precipitates, if produced, may be accumulated at the lower part of the tank 26a and may not be adhered to the roller 9 and the squeegee rollers 8. It is thereby possible to change the developing solution for new one only about once a week or two weeks without changing it every day.

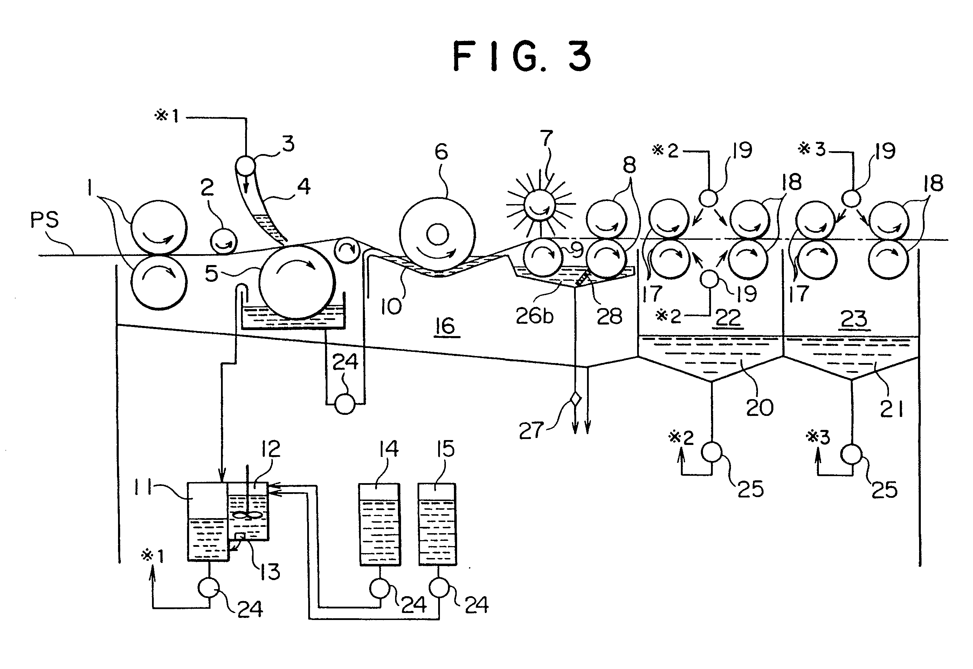

Fig. 3 is a cross-sectional illustration of still another example of a processing apparatus of the present invention. In this example, a tank 26b that holds a developing solution and the developing tank 10 are connected so that an overflow from the developing tank 10 may enter in the tank 26b. The tank 26b is so constituted as to have a small depth as in the case of the tank 26 in Fig. 1. The developing solution in the developing tank 10 and the developing solution in the tank 26b are changed for new ones, for example, every day before operations are started. In Figs. 1 to 3, the same numerals with asterisks (*1 and *1, *2 and *2, *3 and *3) are connected through piping.

In the photographic processing according to the present invention, the developing solution that has not been substantially used is first fed to a PS plate. Here, the developing solution that has not been substantially used is meant to be a developing solution that has not been used or a developing solution having substantially the same developability as the developing solution that has not been used. The developing solutions used in the present invention may be selected from those suited to PS plates to be processed. A post-processing of PS plates having been processed according to the present invention may be carried out by any conventional methods.

The PS plates to be processed according to the apparatus of the present invention are of the type they are developed by dissolving-out, including, for example, those usually called PS plates of a negative type or positive type, and also those of the type a lithographic printing plate has on its plate surface a layer having the properties of being dissolved out to a developing solution capable of providing imagewise a resist layer by electrophotography or the like.

Preferred embodiments of the present invention are as follows:

(1) The immersing tank in which the roller provided beneath the development accelerating means and the lower squeegee roller are immersed comprises a shallow vat, and the developing solution held therein is changed once a day to once in 14 days.

(2) The above vat has a capacity of from 1 to 10 lit.

(3) The automatic processor according to the present invention has a means for feeding to the immersing tank a developing solution that has not been used.

(4) At least one of the roller provided beneath the development accelerating means and the lower roller of the squeegee rollers is continuously rotated.

(5) At least one of the roller provided beneath the development accelerating means and the lower roller of the squeegee rollers is intermittently rotated at given given intervals.

(6) A squeegee plate is brought into contact with the lower roller so that stains adhered to the rollers can be scraped off (in a developing solution).

(7) The development accelerating means comprises a brush roller.

(8) The roller beneath the brush roller of the development accelerating means comprises a brush roller.

## EXAMPLES

The present invention will be described below in greater detail. The present invention is by no means limited to these. In the following, "part(s)" refers to "part(s) by weight".

### Example 1

In a concentrated developing solution tank 14 of the automatic processor as shown in Fig. 1, a concentrated developing solution with the following composition was charged.

| | |
|---|---|
| Pure water | 430 parts |
| Benzyl alcohol | 10 parts |
| Benzoic acid | 80 parts |
| Aqueous 50 % sodium hydroxide solution | 200 parts |
| Emulgen 147 | 3 parts |
| (A nonionic surface active agent produced by Kao Corporation) | |
| Aqueous sodium silicate solution | 200 parts |
| (JIS Sodium Silicate #3) | |
| Aqueous 40 % sodium sulfite solution | 300 parts |

| | |
|---|---|
| In a washing water tank 20, 15 lit. of water was charged, and in a gum solution tank 21, 10 lit. of a gum solution with the composition shown below. | |

| | |
|---|---|
| Gum arabic | 5 parts |
| Dextrin | 15 parts |
| Phosphoric acid (75 %) | 0.3 part |
| Water | 80 parts |
| Sodium di-2-ethylhexylsulfosuccinate | 1.0 part |
| Nonylphenol polyethylene oxide ether | 1.0 part |
| (Ethylene oxide molar number: 6) | |
| Stearic acid | 1.0 part |
| Sorbitan monooleate | 1.0 part |
| Dibutyl phthalate | 2.0 parts |

The transport speed of the automatic processor was so set that the developing time was 20 seconds. Negative PS plates SWN and positive PS plates SMP-N (both produced by Konica Corporation; SMP-N only was exposed to light for 40 seconds at a distance of 60 cm from a 2 kW metal halide lamp) of 1,003 mm x 800 mm each in size were processed in a proportion of 1:1. The above concentrated developing solution was diluted to 1/6 with water in a developing solution mixing tank 12. The diluted developing solution is fed to PS plate surfaces through the developing solution feeding member 4. The feed of the developing solution was controlled to be 200 ml per 1 m², and the developing solution temperature was so set as to be 27° C in the developing solution feeding member 4 and the developing tank 10. Into the immersing tank 26, a developing solution obtained by diluting the above concentrated developing solution to 1/6 with water was charged in an amount of 1 lit. The developing solution in the immersing tank and the washing water were so made as to be changed every day. The brush roller 7, brush guide roller 9 and squeegee rollers 8 were kept always rotated also when the feeding of PS plates was stopped.

Under conditions as described above, the above PS plates were processed by 100 plates a day over a period of a month. No foreign matters, however, were seen to have been adhered to the plates having been processed. It was also tried to serve SPO-1 (a developing ink produced by Konica Corporation) on a plate surface, but no stains were produced at all.

Comparative Example 1

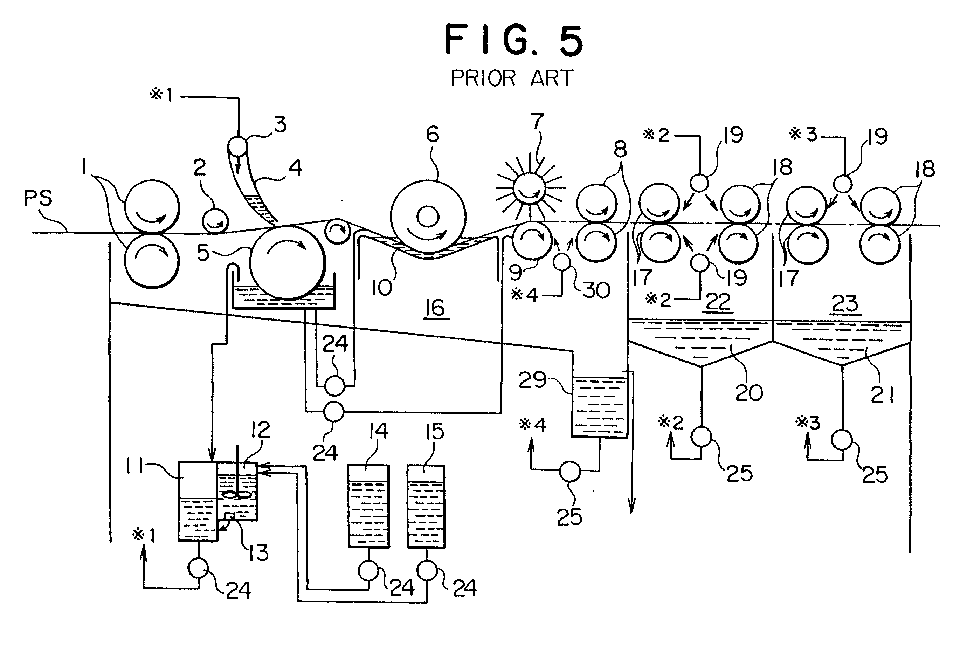

Using the automatic processor as shown in Fig. 5, an experiment was carried out in the same manner as in Example 1. In the case of this automatic processor, the immersing tank filled with the developing solution in which the rollers are immersed is not used. Instead, a developing solution obtained by diluting to 1/6 the concentrated developing solution as used in Example 1 was charged into a developing tank 29 in an amount of 5 lit., and was fed to the brush roller 7, brush guide roller 9 and squeegee rollers 8 by means of the shower pipe 30 so that they were cleaned. The developing solution overflowed from the developing tank 10 and the developing solution sweeped off with the squeegee rollers 8 are led into the developing tank 29, and the developing solution overflowed therefrom is thrown away. The developing solution in the developing tank 29 was not changed during the processing.

Under conditions as described above, PS plates were processed in the same manner as in Example 1. As a result, the shower pipe 30 was clogged in the first week. Unless the inside of the pipe was cleaned, the processed plate caused stains and it was impossible to continue the processing. Moreover, the shower pipe 30 was again clogged in the second week. Accordingly, the inside of the pipe was cleaned and the processing was tried to be continued. However, precipitates generated in the developing tank 29 adhered to the brush roller 7 and squeegee rollers 8 through the shower pipe 30, and were then transferred to the surfaces of PS plates to stain them, so that it was necessary to change the developing solution in the developing tank 29 for new one. The processing was further continued, but consequently a pump stopped because of hard precipitates adhered to the inside of a pump 25 of a developing zone 16.

Example 2

Using the automatic processor as shown in Fig. 2, an experiment was carried out in the same manner as in Example 1, except that, as the immersing tank, a tank (26a) with a capacity of 5 lit was used and the developing solution held in it was changed once a week. The same results as in Example 1 were obtained.

Example 3

In the automatic processor as shown in Fig. 3, an experiment was carried out in the same manner as in Example 1, except that a solution with the composition shown below was used as the concentrated developing solution and SMP-N plates only were used as the PS plates to be processed.

Composition of concentrated developing solution:

| Pure water | 600 parts |
| Benzoic acid | 100 parts |
| Aqueous 50 % sodium hydroxide solution | 250 parts |
| Emulgen 147 | 5 parts |
| (A nonionic surface active agent produced by Kao Corporation) | |
| Aqueous sodium silicate solution | 150 parts |
| (JIS Sodium Silicate #3) | |

The same results as in Example 1 were obtained.

Example 4

An experiment was carried out in the same manner as in Example 1, except that the brush roller 7 and brush guide roller 9 were rotated for 10 seconds at intervals of 5 minutes while the feeding of PS plates was stopped. The same results as in Example 1 were obtained.

Example 5

An experiment was carried out in the same manner as in Example 2, except that the brush roller 7 and brush guide roller 9 were rotated for 30 seconds at intervals of 10 minutes while the feeding of PS plates was stopped. The same results as in Example 2 were obtained.

Example 6

An experiment was carried out in the same manner as in Example 3, except that the brush roller 7 and brush guide roller 9 were rotated for 20 seconds at intervals of 5 minutes while the feeding of PS plates was stopped. The same results as in Example 3 were obtained.

Example 7

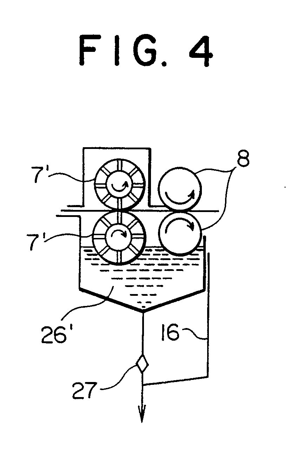

An experiment was carried out in the same manner as in Example 1, except that the part 26 of the automatic processor in Example 1 was replaced with the immersing tank as shown in Fig. 4, and the brush rollers 7' were rotated for 50 seconds at intervals of 1.5 hours while no PS plates were processed. The same results as in Example 1 were obtained.

**Claims**

1. An apparatus for developing an imagewise exposed pre-sensitized lithographic printing plate having a support and a light-sensitive layer with a developing solution that has not been substantially used, comprising;
   (a) a means for applying the developing solution onto the surface of the light-sensitive layer,
   (b) a brush roller for accelerating development and a roller provided beneath the brush roller,
   (c) a pair of squeegee rollers for removing the developing solution from the surface of the light-sensitive layer consisting of an upper roller and a lower roller, and
   (d) a means for passing said plate between said brush roller and said roller provided beneath the brush roller and then between said pair of squeegee rollers,
   said roller provided beneath the brush roller and said lower roller being immersed in a tank that holds an aqueous alkaline solution and said brush roller and said upper roller not being immersed in said tank.
2. The apparatus of claim 1, wherein said roller provided beneath the brush roller is a second brush roller.
3. The apparatus of claim 1, wherein said aqueous alkaline solution is a developing solution.
4. The apparatus of claim 1, wherein at least one of said roller provided beneath the brush roller and said lower roller is continuously rotated.

5. The apparatus of claim 1, wherein at least one of said roller provided beneath the brush roller and said lower roller is intermittently rotated at given intervals.

6. The apparatus of claim 2, wherein at least one of said second brush roller and said lower roller is continuously rotated.

7. The apparatus of claim 2, wherein at least one of said second brush roller and said lower roller is intermittently rotated at given intervals.

FIG. 1

# F I G. 2

EP 0 423 782 A2

FIG. 3

# F I G. 4

# FIG. 5

PRIOR ART

EP 0 423 782 A2